# EUROPÄISCHE PATENTSCHRIFT

(11) **EP 3 787 038 B1**
(45) Veröffentlichungstag und Bekanntmachung des Hinweises auf die Patenterteilung: **04.08.2021**
(21) Anmeldenummer: 20000288.9
(22) Anmeldetag: 17.08.2020
(51) Int. Cl.: H01L 31/0687, H01L 31/0224, H01L 31/18

(54) **ZWEISTUFIGES LOCH-ÄTZVERFAHREN**
TWO STAGE HOLE ETCHING METHOD
PROCÉDÉ D'ATTAQUE CHIMIQUE DE TROUS EN DEUX ÉTAPES

(30) Priorität: 29.08.2019 DE 102019006094
(43) Veröffentlichungstag der Anmeldung: 03.03.2021
(73) Patentinhaber: AZUR SPACE Solar Power GmbH, 74072 Heilbronn (DE)
(72) Erfinder: Köstler, Wolfgang, 74074 Heilbronn (DE)
(74) Vertreter: Koch Müller Patentanwaltsgesellschaft mbH

(56) Entgegenhaltungen:
- CN-A- 103 441 155
- RU-C1- 2 354 009
- LAFONTAINE M ET AL: "High Aspect Ratio and Low Damage III-V/Ge Heterostructure Via Etching (Abstract & Presentation)", PLASMA ETCH AND STRIP IN MICROELECTRONICS (PESM), 11TH INTERNATIONAL WORKSHOP; GRENOBLE, FRANCE; MAY 20-21, 2019, HAL CCSD, FR , 20. Mai 2019 (2019-05-20), Seiten 1-18, XP009524148, Gefunden im Internet: URL:https://hal.archives-ouvertes.fr/hal-0 2324782/
- OLIVIER RICHARD ET AL: "Through cell vias contacts for multijunction solar cells", AIP CONFERENCE PROCEEDINGS, Bd. 1679, 2015, Seite 060003, XP055288761, NEW YORK, US ISSN: 0094-243X, DOI: 10.1063/1.4931537
- DE LAFONTAINE MATHIEU ET AL: "Influence of plasma process on III-V/Ge multijunction solar cell via etching", SOLAR ENERGY MATERIALS AND SOLAR CELLS, Bd. 195, 4. März 2019 (2019-03-04), Seiten 49-54, XP085651399, ISSN: 0927-0248, DOI: 10.1016/J.SOLMAT.2019.01.048
- MATHIEU DE LAFONTAINE ET AL: "Impact of Via Hole Integration on Multijunction Solar Cells for Through Cell Via Contacts and Associated Passivation Treatment", IEEE JOURNAL OF PHOTOVOLTAICS, Bd. 7, Nr. 5, 18. August 2017 (2017-08-18) , Seiten 1456-1461, XP055751765, US ISSN: 2156-3381, DOI: 10.1109/JPHOTOV.2017.2711423
- DE LAFONTAINE M ET AL: "Anisotropic and Low Damage III-V/Ge Heterostructures via Etching for Multijunction Photovoltaic Cell Fabrication", PLASMA ETCH AND STRIP IN MICROELECTRONICS (PESM), 10TH INTERNATIONAL WORKSHOP; LEUVEN, BELGIUM; OCTOBER 19-20 2017, BELGIUM , 19. Oktober 2017 (2017-10-19), Seiten 1-17, XP009524147, Gefunden im Internet: URL:https://hal.univ-grenoble-alpes.fr/hal -01929191
- MATHIEU DE LAFONTAINE ET AL: "Via sidewall insulation for through cell via contacts", AIP CONFERENCE PROCEEDINGS, Bd. 1881, 2017, Seiten 040002-1, XP055579508, NEW YORK, US ISSN: 0094-243X, DOI: 10.1063/1.5001424

## Beschreibung

Die Erfindung betrifft Zweistufiges Loch-Ätzverfahren.

Um die Abschattung der Vorderseite einer Solarzelle zu reduzieren, ist es möglich, sowohl die positive als auch die negative externe Kontaktfläche auf der Rückseite anzuordnen. Bei sogenannte metal wrap through (MWT) - Solarzellen wird die Solarzellenvorderseite beispielsweise durch eine Durchgangskontaktöffnung von der Rückseite aus kontaktiert.

Es sind unterschiedliche Verfahren zur Herstellung eines Loch bzw. einer Durchgangskontaktöffnung durch eine Solarzelle bekannt.

Aus "Die Metal Wrap Through Solarzelle - Entwicklung und Charakterisierung", F. Clement, Dissertation, Februar 2009 ist Herstellungsverfahren für eine MWTeinfach-Solarzelle aus multikristallinem Silizium bekannt, wobei die Durchgangskontaktöffnungen mittels eines UV-Lasers oder eines IR-Lasers in einer mc Si-Substratschicht erzeugt werden.

Erst anschließend wird mittels Phosphordiffusion entlang der Oberseite, der Seitenflächen der Durchgangskontaktöffnung und der Unterseite der Solarzelle eine Emitterschicht erzeugt. Die Durchgangskontaktöffnung wird mit mittels Siebdrucks mit einer leitfähigen Via-Paste, z.B. einer Silberpaste, gefüllt.

Mit dem Laser kann eine sehr glatte Seitenfläche im Bereich des Durchgangslochs erreicht werden, außerdem treten bei einem Laser-Ablations-Prozess keine Hinterschneidungen auf. Das Erzeugen eines Lochs durch einen bestehenden pn-Übergang mittels Laser-Ablation würde allerdings zu Kurzschlüssen führen.

Aus LAFONTAINE M ET AL: "High Aspect Ratio and Low Damage III-V/Ge Heterostructure Via Etching (Abstract & Presentation)", PLASMA ETCH AND STRIP IN MICROELECTRONICS (PESM), 11th INTERNATIONAL WORKSHOP; 20. Mai 2019, Seiten 1-18, OLIVIER RICHARD ET AL: "Through cell vias contacts for multijunction solar cells", AIP CONFERENCE PROCEEDINGS, Bd. 1679, 2015, Seite 060003, CN 103 441 155 A, RU 2 354 009 C1, und aus DE LAFONTAINE MATHIEU ET AL: "Influence of plasma process on III-V/Ge multijunction solar cell via etching", SOLAR ENERGY MATERIALS AND SOLAR CELLS, Bd. 195, 04. März 2019, Seiten 49-54, und aus MATHIEU DE LAFONTAINE ET AL: "Impact of Via Hole Integration on Multijunction Solar Cells for Through Cell Via Contacts and Associated Passivation Treatment", IEEE JOURNAL OF PHOTOVOLTAICS; Bd. 7, Nr. 5, 18. August 2017, Seiten 1456-1461, und aus DE LAFONTAINE M ET AL: "Anisotropie and Low Damage III-V/Ge Heterostructures via Etching for Multijunction Photovoltaic Cell Fabrication", PLASMA ETCH AND STRIP IN MICROELECTRONICS (PESM), 10th INTERNATIONAL WORKSHOP; LEUVEN, BEL-GIUM; 19. Oktober 2017, Seiten 1-17, und aus MATHIEU DE LAFONTAINE ET AL: "Via sidewall insulation for through cell via contacts", AIP CONFERENCE PROCEEDINGS, Bd. 1881, 2017, Seiten 040002-1 sind Verfahren und Vorrichtungen auf dem Gebiet der Durchkontaktierung bekannt.

Aus "III-V multi-junction metal-wrap-through (MWT) concentrator solar cells", E. Oliva et al., Proceedings, 32nd European PV Solar Energy Conference and Exhibition, München, 2016, pp. 1367-1371, ist eine invertiert gewachsene GaInP/AlGaAs Solarzellenstruktur mit Durchgangskontaktöffnungen bekannt, wobei die Solarzellenstruktur mit den pn-Übergängen epitaktisch gewachsen und ersten anschließend die Durchgangskontaktöffnungen mittels Trockenätzen erzeugt wird. Eine Seitenfläche der Durchgangsöffnung wird anschließend mit einer Isolationsschicht beschichtet und die Durchgangsöffnung werden anschließend mit galvanisiertem Kupfer gefüllt.

Aus der US 9,680,035 B1 ist ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hinein reichendes Loch mittels eines nasschemischen Ätzprozesses erzeugt wird.

Der Ätzprozess basiert darauf, dass sich die Ätzraten zumindest für die verwendeten unterschiedlichen III-V-Materialien des Solarzellenstapels nicht Wesentlich unterschieden. Das Loch wird erst durch Dünnen der Substratschicht nach unten geöffnet. Eine Passivierung und Metallisierung der Vorderseite und des Lochs wird vor dem Dünnen der Substratschicht durchgeführt.

Das nasschemische Ätzen hat im Vergleich zu entsprechenden Trockenätzprozessen den Vorteil, dass die Seitenwände des Lochs eine glattere Oberfläche aufweisen und die Passivierungsschicht konform und ohne Fehlstellen abgeschieden werden kann.

Vor diesem Hintergrund besteht die Aufgabe der Erfindung darin, eine Vorrichtung anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein zweistufiges Loch-Ätzverfahren bereitgestellt, mindestens umfassend die Schritte:
- Bereitstellen einer Halbleiterscheibe mit einer Oberseite und einer Unterseite umfassend mehrere Solarzellenstapel jeweils in der genannten Reihenfolge aufweisend ein die Unterseite ausbildendes Ge-Substrat, eine Ge-Teilzelle und mindestens zwei III-V-Teilzellen, sowie
- Durchführen von einem ersten Prozessabschnitt und einem zweiten Prozessabschnitt in der genannten Reihenfolge.

In dem ersten Prozessabschnitt wird eine erste Lackschicht auf der Oberseite der Halbleiterscheibe aufgebracht, mindestens eine erste Öffnung in der ersten

Lackschicht erzeugt und mittels eines ersten Ätzprozesses in dem Bereich der ersten Öffnung ein von der Oberseite der Halbleiterscheibe durch die III-V-Teilzellen zumindest bis über einen pn-Übergang der Ge-Teilzelle hinaus in die Halbleiterscheibe hinein reichendes Loch erzeugt.

In dem zweiten Prozessabschnitt wird eine zweite Lackschicht auf die Oberseite der Halbleiterscheibe aufgebracht, eine im Vergleich zu der ersten Öffnung größere und das Loch umschließende zweite Öffnung in der zweiten Lackschicht erzeugt und mittels eines zweiten Ätzprozesses das Loch in dem Bereich der zweiten Öffnung in einem von der Oberseite der Halbleiterscheibe bis zu der als Ätzstoppschicht dienenden Ge-Teilzelle reichenden Bereich verbreitert.

Es versteht sich, dass zwischen den Prozessschritten die erste Lackschicht entfernt wird.

Es versteht sich, dass die einzelnen Teilzellen der Solarzellenstapel jeweils einen pn-Übergang aufweisen und die auf das Substrat folgenden Schichten epitaktisch aufeinander erzeugt und/oder mittels Wafer-Bond miteinander verbunden sind.

Außerdem versteht es sich, dass eine Ge-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält. Entsprechendes gilt auch für die III-V-Teilzellen, welche ein oder mehrere Materialien der III. sowie der V. Hauptgruppe aufweisen oder aus solchen Materialien bestehen.

Die Aufteilung der Erzeugung des Lochs auf zwei Prozessabschnitt bzw. zwei unterschiedliche Ätzprozesse ermöglicht es, die Ätzprozesse jeweils an die unterschiedlichen Materialien anzupassen.

So werden in dem ersten Ätzprozess alle Teilzellen, also sowohl die III-V-Materialien der III-V-Teilzellen und gegebenenfalls weiterer III-V-Schichten als auch die Ge-Teilzelle geätzt, während in dem zweiten Ätzprozess selektiv nur die III-V-Materialien der III-V-Teilzellen und gegebenenfalls weiterer III-V-Schichten geätzt werden und die Ge-Teilzelle als Stopp-Schicht dient.

Weitere III-V-Schichten sind beispielsweise Pufferschichten oder eine Deckschicht, auch Cap-Layer genannt.

Die Reihenfolge verhindert insbesondere Unterätzungen im hergestellten Loch, welche ein Anhaften von weiteren Schichten, wie einer Passivierungsschicht, erschweren. Der erste Ätzprozess führt typischerweise zu Unterätzungen im Bereich der Ge-Teilzelle, also unterhalb der III-V-Teilzellen.

Die Unterätzungen verschwinden durch das Verbreitern des Lochs im Bereich der III-V-Teilzellen durch den zweiten Prozessabschnitt wieder. Außerdem führt der zweite Ätzprozess zu Unterätzungs-freien relativ glatten Oberflächen im Bereich der III-V-Teilzellen.

Das erzeugte Loch weist eine durch die Oberseite der Ge-Teilzelle ausgebildete umlaufende Stufe auf, an der sich ein Lochdurchmesser sprunghaft nach unten hin verringert.

Mittels des Verfahrens wird also sichergestellt, dass sich im Bereich der Durchgangsöffnung keine Unterätzungen bzw. Hinterschneidungen ausbilden. Dies ist notwendig, damit eine Passivierung über die gesamte Länge der Durchgangsöffnung, insbesondere im Bereich der Kanten bzw. Stufen, zuverlässig haftet und sich keine Fehlstellen innerhalb der Passivierungsschicht ausbilden. Fehlstellen könnten zu Kurzschlüssen der Teilzellen führen.

Eine Durchgangsöffnung, also ein Öffnen des Lochs durch die restliche Ge-Teilzelle und das Ge-Substrat, Ist anschließend auf einfache und schnelle weise z.B. mittels Laser-Ablation möglich, ohne dass die pn-Übergänge Schaden nehmen bzw. es zu Kurzschlüssen kommt.

In einer Weiterbildung weist das in den zwei Prozessabschnitten geätzte Loch in einem von der Oberseite der Halbleiterscheibe bis zu einer Oberseite der Ge-Teilzelle reichenden ersten Bereich ein Aspektverhältnis von Tiefe zu mittlerer Breite von höchstens 0,05 oder von höchstens 0,01 auf.

Beispielsweise beträgt die Tiefe des Lochs zwischen 5 µm und 15 µm, während die Höhe zwischen 300 µm und 500 µm beträgt.

Die Gesamthöhe des Lochs wird im Wesentlichen durch die Schichtdicken der Teilzellen bestimmt. Während die mindestens zwei III-V Teilzellen vollständig von dem Loch durchdrungen werden sollen, richtet sich die Eindringtiefe in die Ge-Teilzelle nach der Position des pn-Übergangs der Ge-Teilzelle. Das Loch wird mindestens so weit in die Ge-Teilzelle hinein geätzt, dass sich ein Lochboden unterhalb des pn Übergangs befindet.

Es versteht sich, dass die Tiefe des Lochs im Wesentlichen bereits mit dem ersten Prozessabschnitt, also dem ersten Ätzprozess erreicht wird, während die größte Breite, also die Breite im oberen Bereich des Lochs erst mit dem zweiten Prozessabschnitt, also dem zweiten Ätzprozess erzielt wird.

In einer anderen Ausführungsform weisen die III-V-Teilzellen der bereitgestellten Halbleiterscheibe eine gemeinsame Schichtdicke von 5 - 15 µm oder von 6 - 8 µm auf.

Gemäß einer weiteren Ausführungsform weist das mit dem ersten und zweiten Prozessabschnitt erzeugte Loch an der Oberseite der Halbleiterscheibe einen Durchmesser von mindestens 300 µm oder mindestens 400 µm oder mindestens 450 µm aufweist, wobei der Durchmesser nicht größer als 1 mm ist. Es versteht sich, dass die Breite an der Oberseite der Halbleiterscheibe im Wesentlichen durch den zweiten Prozessabschnitt, also die zweite Öffnung in der zweiten Lackschicht und den zweiten Ätzprozess bestimmt wird.

In einer anderen Weiterbildung weist das in dem ersten und zweiten Prozessabschnitt erzeugte Loch in einem von der Oberseite der Halbleiterscheibe bis zu einer Oberseite der Ge-Teilzelle reichenden ersten Bereich einen mit zunehmender Tiefe gleich bleibenden oder abnehmenden Durchmesser auf, wobei ein Winkel der Seitenflächen des ersten Bereichs zu einer Lotgeraden einer Bodenfläche des Lochs höchstens 10° oder höchstens 2° oder höchstens 1° oder höchstens 0,1° beträgt.

Gemäß einer weiteren Weiterbildung weist das in dem ersten und zweiten Prozessabschnitt erzeugte Loch in einem von einer Oberseite der Ge-Teilzelle in die Ge-Teilzelle hinein reichenden Bereich einen Durchmesser von mindestens 150 µm oder mindestens 200 µm auf. Es versteht sich, dass die Breite an der Oberseite der Ge-Teilzelle im Wesentlichen durch den ersten Prozessabschnitt, also die erste Öffnung in der ersten Lackschicht und den ersten Ätzprozess bestimmt wird.

In einer anderen Ausführungsform weist die Ge-Teilzelle zusammen mit der Ge-Substratschicht der bereitgestellten Halbleiterscheibe eine Schichtdicke von 80 - 300 µm oder von 140 - 160 µm oder von 80 - 120 µm aufweist.

In einer Weiterbildung wird die bereitgestellte Halbleiterscheibe durch Aufwachsen und/oder Wafer-Bonden der Teilzellen auf einem Ge-Substrat mit einer Schichtdicke von mindestens 400 µm und anschließendes dünnen des Ge-Substrats auf eine Dicke von höchstens 300 µm oder höchstens 200 µm oder höchstens 100 µm erzeugt.

Gemäß einer weiteren Ausführungsform weist das in dem ersten und zweiten Prozessabschnitt erzeugte Loch von einer Oberseite der Ge-Teilzelle bis zu einer Bodenfläche des Lochs eine Tiefe von 1 - 4 µm oder von 1 - 3 µm oder von 2 µm auf. Das Loch wird in dem ersten Prozessabschnitt zumindest soweit in die Ge-Teilzelle hinein geätzt, dass es über die die Position des pn-Übergangs der Ge-Teilzelle hinaus verläuft.

In einer weiteren Weiterbildung ist der erste Ätzprozess und/oder der zweite Ätzprozess ein nasschemischer Ätzprozess. Alternativ sind der erste Ätzprozess und/oder der zweite Ätzprozess ein Trockenätzprozess.

Gemäß einer anderen Ausführungsform wird nach dem zweiten Prozessschritt auf die Oberseite der Halbleiterscheibe und auf alle Oberflächen des Lochs ein Schutzlack aufgebracht und mittels Laser-Ablation eine von einer Bodenfläche des Lochs bis zu der Unterseite der Halbleiterscheibe reichende Durchgangsöffnung erzeugt wird.

Eine Durchgangsöffnung ermöglicht es Vorderseitenkontakte auf die Rückseite zu führen und damit die Abschattung der Vorderseite der Solarzellen zu verringern. Der Schutzlack schützt insbesondere alle pn-Übergänge der Solarzellenstapel davor, durch das Einwirken des Lasers aufgeschmolzen zu werden. Außerdem schützt der Schutzlack alle Oberflächen vor der Ablagerung von bei dem Ablations-Prozess entstehendem Schmauch.

In einer anderen Ausführungsform beträgt ein Durchmesser der mittels der Laser-Ablation erzeugten Durchgangsöffnung höchstens 60% oder höchstens 20% oder höchstens 10% eines Durchmessers des Lochs an der Oberseite der Halbleiterscheibe.

In einer weiteren Ausführungsform weisen die erste Öffnung und/oder die zweite Öffnung einen ovalen Umfang aufweisen. Die Öffnungen der Lackschichten sind beispielsweise kreisförmig oder auch elliptisch ausgebildet.

Gemäß einer anderen Weiterbildung wird in dem ersten Prozessschritt oberhalb jedes Solarzellenstapels der Halbleiterscheibe mindestens eine erste Öffnung in der ersten Lackschicht erzeugt. In einer Weiterbildung werden je Solarzellenstapel genau zwei Öffnungen erzeugt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigten, die
- Figur 1: einen Ablauf gemäß einer ersten erfindungsgemäße Ausführungsform eines zweistufigen Loch-Ätzverfahrens,
- Figur 2: eine Aufsicht auf eine Halbleiterscheibe mit einem mittels des erfindungsgemäßen Verfahrens erzeugten Loch,
- Figur 3: eine Aufsicht auf eine Halbleiterscheibe mit mehreren Solarzellenstapeln,
- Figur 4: einen schematischen Ablauf weiterer Verfahrensschritte.

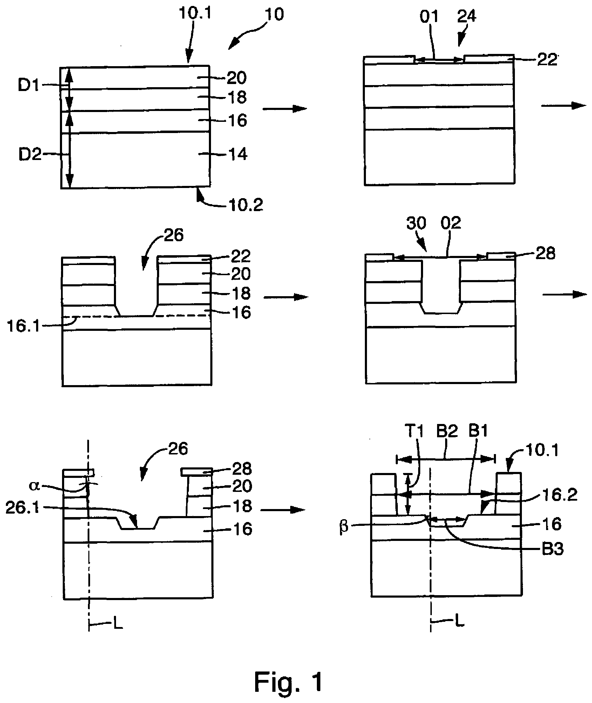

Die Abbildung der Figur 1 zeigt einen schematischen Ablauf eines zweistufigen Loch-Ätzverfahrens gemäß einer ersten erfindungsgemäßen Ausführungsform.

Es wird eine Halbleiterscheibe 10 mit einer Oberseite 10.1, einer Unterseite 10.2 und mehreren Solarzellenstapeln jeweils bestehend aus einer Schichtfolge aus einem die Unterseite 10.1 ausbildenden Ge-Substrat 14, einer Ge-Teilzelle 16, einer ersten III-V-Teilzelle 18 und einer die Oberseite 10.1 ausbildenden zweiten III-V-Teilzelle 20. Dargestellt ist lediglich eine Schnittansicht eines Ausschnitts einer Halbleiterscheibe 10, in dem ein Loch erzeugt werden soll.

Die Ge-Teilzelle 16 zusammen mit dem Ge-Substrat 14 weist eine erste gemeinsamen Schichtdicke D1 und die beiden III-V-Teilzellen 18, 20 weisen eine gemeinsame zweite Schichtdicke D2 auf.

In einem ersten Prozessabschnitt wird auf der Oberseite 10.1 der Halbleiterscheibe 10 eine erste Lackschicht 22 aufgebracht und in der Lackschicht 22 eine erste Öffnung 24 mit einem Durchmesser O1 erzeugt. Anschließend wird mittels eines ersten Ätzprozesses das Material der Halbleiterscheibe 10 nicht selektiv im Bereich der Öffnung 24 entfernt.

Der erste Ätzprozess wird gestoppt, wenn das entstandene Loch 26 über einen pn-Übergang 16.1 der Ge-Teilzelle 16 in die Halbleiterscheibe 10 hineinreicht, so dass sich eine Bodenfläche 26.1 des Lochs 26 unterhalb des pn-Übergangs 16.1 befindet.

Anschließend wird die erste Lackschicht 22 entfernt und in einem zweiten Prozessabschnitt auf der Oberseite 10.1 der Halbleiterscheibe 10 eine zweite Lackschicht 28 aufgebracht. In der zweiten Lackschicht 28 wird eine zweite Öffnung 30 erzeugt, wobei die zweite Öffnung 30 einen zweiten Durchmesser O2 größer als der erste Durchmesser aufweist und das Loch 26 umschließt.

Mittels eines zweiten Ätzprozesses wird dann das Material der beiden III-V-Teilzellen in dem Bereich der zweiten Öffnung 30 bis zu der als Ätzstoppschicht dienenden Ge-Teilzelle 16 entfernt, wodurch das Loch 26 in einem Bereich oberhalb der Ge-Teilzelle 16 breiter wird.

Dann wird auch die zweite Lackschicht 28 wieder entfernt.

Das erzeugte Loch 26 weist an der Oberseite 10.1 der Halbleiterscheibe 10 eine Durchmesser B2 auf. Ein Durchmesser B1 des Lochs 26 in dem Bereich der beiden III-V-Teilzellen 16 und 18 ist entweder konstant oder nimmt nach in Richtung der Ge-Teilzelle ab, so dass eine Seitenfläche des Lochs 26 im Bereich der III-V-Teilzellen 16 und 18 in einem Winkel α zu einer Lot-Geraden L verlaufen.

Eine Oberseite 16.2 der Ge-Teilzelle 16 bildet eine in das Loch 26 hinein ragende Stufe aus, wodurch sich der Durchmesser des Lochs an der Ge-Teilzellenoberseite 16.2 auf einen Durchmesser D3 verringert. Im Bereich der Ge-Teilzelle nimmt der Durchmesser ab, so dass eine Seitenfläche des Lochs im Bereich der Ge-Teilzelle einen Winkel β mit einer Lot-Geraden L einschließt.

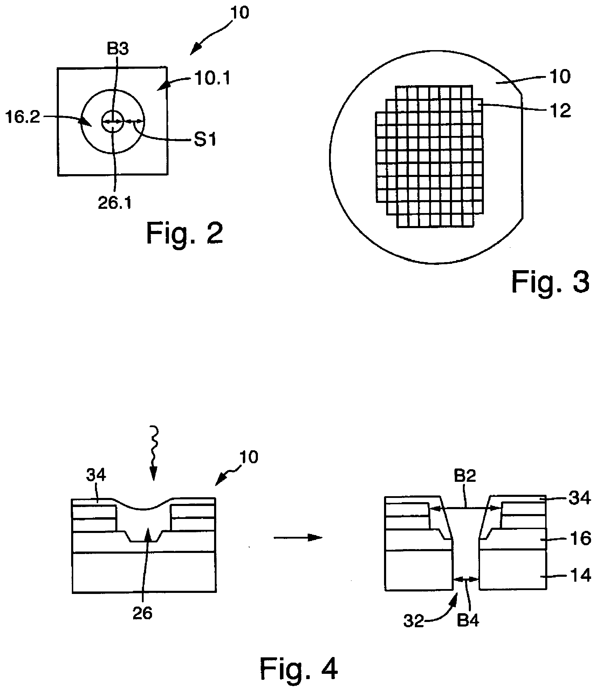

In der Abbildung der Figur 2 Ist eine Aufsicht auf einen ersten Abschnitt einer Halbleiterscheibe 10 mit einem gemäß dem zweistufigen Ätzverfahren erzeugten Loch dargestellt. In dem dargestellten Ausführungsbeispiel ist das Loch kreisförmig ausgebildet, wobei sowohl der Lochboden 26.1 als auch die an die Oberseite 10.1 der Halbleiterscheibe 10 angrenzende Kante des Lochs 26 einen kreisförmigen Umfang bzw. Verlauf aufweisen.

Der Lochboden 26.1 ist in der Aufsicht von der durch die Oberseite 16.2 der Ge-Teilzelle 16 ausgebildeten Stufe S1 umschlossen.

In der Abbildung der Figur 3 ist eine Aufsicht auf eine Halbleiterscheibe 10 mit mehreren Solarzellenstapeln dargestellt. Gemäß einer erfindungsgemä-βen Ausführungsform wird im Bereich jedes Solarzellenstapels mindestens ein Loch mittels des zweistufigen Ätzverfahrens erzeugt, wofür in dem ersten Prozessabschnitt vor dem ersten Ätzprozess oberhalb jedes Solarzellenstapel mindestens eine Öffnung und in dem zweiten Prozessabschnitt entsprechende zweite Öffnungen erzeugt werden.

In der Abbildung der Figur 4 sind weitere Verfahrensschritte schematisch dargestellt. Nach dem Erzeugen des mindestens eine Lochs 26 in der Halbleiterscheibe 10, also nach dem zweiten Prozessabschnitt, wird die Oberseite 10.1 der Halbleiterscheibe 10 mit einem Schutzlack 34 beschichtet.

Dabei füllt sich das Loch 26 zumindest teilweise mit dem Schutzlack 34 bzw. der Schutzlack 34 bedeckt zumindest auch die Oberflächen des Lochs 26. Anschließend wird im Bereich des Bodens 26.1 des Lochs 26 mittels Laser-Ablation eine Durchgangsöffnung 32 mit einem Durchmesser B4 durch den Schutzlacks 34 und einen verbliebenen Teil der Ge-Teilzelle 16 und das Ge-Substrat 14 erzeugt.

### Bezugszeichenliste

- 10: Halbleiterscheibe
- 10.1: Oberseite
- 10.2: Unterseite
- 12: Solarzellenstapel
- 14: Ge-Substrat
- 16: Ge-Teilzelle
- 16.1: pn-Übergang
- 16.2: Oberseite
- 18: III-V-Teilzelle
- 20: III-V-Teilzelle
- 22: erste Lackschicht
- 24: erste Öffnung
- 26: Loch
- 26.1: Bodenfläche
- 28: zweite Lackschicht
- 30: zweite Öffnung
- 32: Durchgangsöffnung
- 34: Schutzlack

## Patentansprüche

1. Zweistufiges Loch-Ätzverfahren mindestens umfassend die Schritte:
- Bereitstellen einer Halbleiterscheibe (10) mit einer Oberseite (10.1) und einer Unterseite (10.2) umfassend mehrere Solarzellenstapel (12) jeweils in der genannten Reihenfolge aufweisend ein die Unterseite ausbildendes Ge-Substrat (14), eine Ge-Teilzelle (16) und mindestens zwei III-V-Teilzellen (18, 20),
- Durchführen von einem ersten Prozessabschnitt und einem zweiten Prozessabschnitt in der genannten Reihenfolge, wobei
- in dem ersten Prozessabschnitt eine erste Lackschicht (22) auf der Oberseite (10.1) der Halbleiterscheibe (10) aufgebracht wird, mindestens eine erste Öffnung (24) in der ersten Lackschicht (22) erzeugt wird und mittels eines ersten Ätzprozesses in dem Bereich der ersten Öffnung (24) ein von der Oberseite (10.1) der Halbleiterscheibe (10) durch die III-V-Teilzellen zumindest bis über einen pn-Übergang (16.1) der Ge-Teilzelle hinaus in die Halbleiterscheibe hinein reichendes Loch (26) erzeugt wird,
- in dem zweiten Prozessabschnitt eine zweite Lackschicht (28) auf die Oberseite (10.1) der Halbleiterscheibe (10) aufgebracht wird, eine im Vergleich zu der ersten Öffnung (24) größere und das Loch (26) umschließende zweite Öffnung (30) in der zweiten Lackschicht (28) erzeugt wird und mittels eines zweiten Ätzprozesses das Loch (26) in dem Bereich der zweiten Öffnung (30) in einem von der Oberseite (10.1) der Halbleiterscheibe (10) bis zu der als Ätzstoppschicht dienenden Ge-Teilzelle (16) reichenden Bereich verbreitert wird.

2. Verfahren nach Anspruch 1, **dadurch gekennzeichnet, dass** das in dem ersten und zweiten Prozessabschnitt erzeugte Loch (26) in einem von der Oberseite (10.1) der Halbleiterscheibe (10) bis zu einer Oberseite (16.2) der Ge-Teilzelle (16) reichenden ersten Bereich ein Aspektverhältnis von Tiefe (T1) zu mittlerer Breite (B1) von höchstens 0,05 oder von höchstens 0,01 aufweist.

3. Verfahren nach Anspruch 1 oder 2, **dadurch gekennzeichnet, dass** die III-V-Teilzellen (18, 20) der bereitgestellten Halbleiterscheibe eine gemeinsame Schichtdicke (D1) von 5 - 15 µm oder von 6 - 8 µm aufweisen.

4. Verfahren nach einem der vorstehenden Ansprüche, **dadurch gekennzeichnet, dass** das in dem ersten und zweiten Prozessabschnitt erzeugte Loch (26) an der Oberseite (10.1) der Halbleiterscheibe (10) einen Durchmesser (B2) von mindestens 300 µm oder mindestens 400 µm oder mindestens 450 µm aufweist , wobei der Durchmesser (B2) nicht größer als 1 mm ist.

5. Verfahren nach einem der vorstehenden Ansprüche, **dadurch gekennzeichnet, dass** das in dem ersten und zweiten Prozessabschnitt erzeugte Loch (26) in einem von der Oberseite (10.1) der Halbleiterscheibe (10) bis zu einer Oberseite (16.2) der Ge-Teilzelle (16) reichenden ersten Bereich einen mit zunehmender Tiefe gleich bleibenden oder abnehmenden Durchmesser (B3) aufweist, wobei ein Winkel (α) der Seitenflächen des ersten Bereichs zu einer Lotgeraden (L) einer Bodenfläche (26.1) des Lochs (26) höchstens 10° oder höchstens 2° oder höchstens 1° oder höchstens 0,1° beträgt.

6. Verfahren nach einem der vorstehenden Ansprüche, **dadurch gekennzeichnet, dass** das in dem ersten und zweiten Prozessabschnitt erzeugte Loch (26) in einem von einer Oberseite (16.2) der Ge-Teilzelle (16) in die Ge-Teilzelle (16) hinein reichenden Bereich einen Durchmesser (B3) von mindestens 150 µm oder mindestens 200 µm aufweist.

7. Verfahren nach einem der vorstehenden Ansprüche, **dadurch gekennzeichnet, dass** die Ge-Teilzelle (16) zusammen mit der Ge-Substratschicht (14) der bereitgestellten Halbleiterscheibe (10) eine Schichtdicke (D2) von 80 - 300 µm oder von 140 - 160 µm oder von 80 - 120 µm aufweist.

8. Verfahren nach einem der vorstehenden Ansprüche, dass das in dem ersten und zweiten Prozessabschnitt erzeugte Loch (26) von einer Oberseite (16.2) der Ge-Teilzelle (16) bis zu einer Bodenfläche (26) des Lochs (26) eine Tiefe von 1 - 4 µm oder von 1 - 3 µm oder von 2 µm aufweist.

9. Verfahren nach einem der vorstehenden Ansprüche, **dadurch gekennzeichnet, dass** der erste Ätzprozess und/oder der zweite Ätzprozess ein nasschemischer Ätzprozess ist.

10. Verfahren nach einem der vorstehenden Ansprüche, **dadurch gekennzeichnet, dass** der erste Ätzprozess und/oder der zweite Ätzprozess ein Trockenätzprozess ist.

11. Verfahren nach einem der vorstehenden Ansprüche, **dadurch gekennzeichnet, dass** nach dem zweiten Prozessschritt auf die Oberseite (10.1) der Halbleiterscheibe (10) und auf alle Oberflächen des Lochs (26) ein Schutzlack aufgebracht wird und mittels Laser-Ablation eine von einer Bodenfläche (16.2) des Lochs (26) bis zu der Unterseite (10.2) der Halbleiterscheibe (10) reichende Durchgangsöffnung (32) erzeugt wird.

12. Verfahren nach Anspruch 11, **dadurch gekennzeichnet, dass** ein Durchmesser (B4) der mittels der Laser-Ablation erzeugten Durchgangsöffnung (32) höchstens 60% oder höchstens 20% oder höchstens 10% eines Durchmessers (B2) des Lochs (26) an der Oberseite (10.1) der Halbleiterscheibe (10) beträgt.

13. Verfahren nach einem der vorstehenden Ansprüche, **dadurch gekennzeichnet, dass** die erste Öffnung (24) und/oder die zweite Öffnung (30) einen ovalen Umfang aufweisen.

14. Verfahren nach einem der Ansprüche, **dadurch gekennzeichnet, dass** in dem ersten Prozessschritt oberhalb jedes Solarzellenstapels (12) der Halbleiterscheibe (10) mindestens eine erste Öffnung (24) in der ersten Lackschicht (22) erzeugt wird.

## Claims

1. Two-stage hole etching method comprising at least the steps:
- providing a semiconductor wafer (10) with a plurality of solar cell stacks (12) which comprise an upper side (10.1) and a lower side (10.2) and which each have in the stated sequence a Ge substrate (14) forming the lower side, a Ge part cell (16) and at least two III-V part cells (18, 20),
- carrying out a first method phase and a second method phase in the stated sequence, wherein
- in the first method phase a first coating layer (22) is applied to the upper side (10.1) of the semiconductor wafer (10), at least one first opening (24) is produced in the first coating layer (22) and by means of a first etching process a hole (26) reaching into the semiconductor wafer from the upper side (10.1) of the semiconductor wafer (10) through the III-V part cells at least to beyond a pn-transition (16.1) of the Ge part cell is produced in the area of the first opening (24),
- in the second method phase a second coating layer (28) is applied to the upper side (10.1) of the semiconductor wafer (10), a second opening (30), which is larger by comparison with the first opening (24) and encloses the hole (26), is produced in the second coating layer (28) and by means of a second etching process the hole (26) is widened in the area of the second opening (30) in a region reaching from the upper side (10.1) of the semiconductor wafer (10) to the Ge part cell (16) serving as an etching stop layer.

2. Method according to claim 1, **characterised in that** the hole (26) produced in the first and second method phases has in a first region reaching from the upper side (10.1) of the semiconductor wafer (10) to an upper side (16.2) of the Ge part cell (16) an aspect ratio of depth (T1) to mean width (B1) of at most 0.05 or at most 0.01.

3. Method according to claim 1 or 2, **characterised in that** the III-V part cells (18, 20) of the provided semiconductor wafer have a common layer thickness (D1) of 5 - 15 µm or 6 - 8 µm.

4. Method according to any one of the preceding claims, **characterised in that** the hole (26) produced in the first and second method phases has at the upper side (10.1) of the semiconductor wafer (10) a diameter (B2) of at least 300 µm or at least 400 µm or at least 450 µm, wherein the diameter (B2) is not larger than 1 mm.

5. Method according to any one of the preceding claims, **characterised in that** the hole (26) produced in the first and second method phases has in a first region reaching from the upper side (10.1) of the semiconductor wafer (10) to an upper side (16.2) of the Ge part cell (16) a diameter (B3) which with increasing depth remains the same or decreases, wherein an angle (α) of the side surfaces of the first region with respect to a vertical straight line (L) of a base area (26.1) of the hole (26) is at most 10° or at most 2° or at most 1° or at most 0.1°.

6. Method according to any one of the preceding claims, **characterised in that** the hole (26) produced in the first and second method phases has in a region reaching from an upper side (16.2) of the Ge part cell (16) into the Ge part cell (16) a diameter (B3) of at least 150 µm or at least 200 µm.

7. Method according to any one of the preceding claims, **characterised in that** the Ge part cell (16) together with the substrate layer (14) of the provided semiconductor wafer (10) has a layer thickness (D2) of 80 - 300 µm or 140 - 160 µm or 80 - 120 µm.

8. Method according to any one of the preceding claims, **characterised in that** the hole (26) produced in the first and second method phases has from an upper side (16.2) of the Ge part cell (16) to a base area (26) of the hole (26) a depth of 1 - 4 µm or 1 - 3 µm or 2 µm.

9. Method according to any one of the preceding claims, **characterised in that** the first etching process and/or the second etching process is or are each a wet-chemical etching process.

10. Method according to any one of the preceding claims, **characterised in that** the first etching process and/or the second etching process is or are each a dry-etching process.

11. Method according to any one of the preceding claim, **characterised in that** after the second process step a protective coating is applied to the upper side (10.1) of the semiconductor wafer (10) and to all surfaces of the hole (26) and a passage opening (32) reaching from a base area (16.2) of the hole (26) to the lower side (10.2) of the semiconductor wafer (10) is produced by means of laser ablation.

12. Method according to claim 11, **characterised in that** a diameter (B4) of the passage opening (32) produced by means of the laser ablation is at most 60% or at most 20% or at most 10% of a diameter (B2) of the hole (26) at the upper side (10.1) of the semiconductor wafer (10).

13. Method according to any one of the preceding claims, **characterised in that** the first opening (34) and/or the second opening (30) has or each have an oval circumference.

14. Method according to any one of the claims, **characterised in that** in the first process step at least one first opening (24) is produced in the first coating layer (22) above each solar cell stack (12) of the semiconductor wafer (10).

## Revendications

1. Procédé de gravure de trou en deux phases comprenant au moins les étapes suivantes :
- préparation d'une plaquette semi-conductrice (10) avec une face supérieure (10.1) et une face inférieure (10.2) comprenant plusieurs piles de cellules solaires (12) présentant chacune dans cet ordre de succession un substrat en Ge (14) constituant la face inférieure, une sous-cellule en Ge (16) et au moins deux sous-cellules III-V (18, 20),
- réalisation d'une première partie de processus et d'une deuxième partie de processus dans cet ordre de succession, selon lequel
- dans la première partie de processus, une première couche de vernis (22) est appliquée sur la face supérieure (10.1) de la plaquette semi-conductrice (10), au moins une première ouverture (24) est réalisée dans la première couche de vernis (22) et, au moyen d'un premier processus de gravure, dans la zone de la première ouverture (24), un trou (26) est réalisé dans la plaquette semi conductrice, allant de la face supérieure (10.1) de la plaquette semi-conductrice (10), à travers les sous-cellules III-V, au moins jusqu'au-delà d'une jonction p-n (16.1) de la sous-cellule en Ge,
- dans la deuxième partie de processus, une deuxième couche de vernis (28) est appliquée sur la face supérieure (10.1) de la plaquette semi-conductrice (10), une deuxième ouverture (30) plus grande que la première ouverture (24) et entourant le trou (26) est réalisée dans la deuxième couche de vernis (28) et, au moyen d'un deuxième processus de gravure, le trou (26) dans la zone de la deuxième ouverture (30) est élargi dans une zone allant de la face supérieure (10.1) de la plaquette semi-conductrice (10) à la sous-cellule en Ge (16) faisant office de couche d'arrêt de la gravure.

2. Procédé selon la revendication 1, **caractérisé en ce que** le trou (26) réalisé dans la première et la deuxième partie de processus présente dans une première zone allant de la face supérieure (10.1) de la plaquette semi-conductrice (10) à une face supérieure (16.2) de la sous-cellule en Ge (16) un rapport d'aspect entre la profondeur (T1) et la largeur moyenne (B1) de 0,05 au maximum ou de 0,01 au maximum.

3. Procédé selon la revendication 1 ou 2, **caractérisé en ce que** les sous-cellules III-V (18, 20) de la plaquette semi-conductrice préparée présentent une épaisseur de couche commune (D1) de 5 à 15 µm ou de 6 à 8 µm.

4. Procédé selon l'une des revendications précédentes, **caractérisé en ce que** le trou (26) réalisé dans la première et la deuxième partie de processus présente sur la face supérieure (10.1) de la plaquette semi-conductrice (10) un diamètre (B2) d'au moins 300 µm ou d'au moins 400 µm ou d'au moins 450 µm, le diamètre (B2) n'excédant pas 1 mm.

5. Procédé selon l'une des revendications précédentes, **caractérisé en ce que** le trou (26) réalisé dans la première et la deuxième partie de processus présente dans une première zone allant de la face supérieure (10.1) de la plaquette semi-conductrice (10) à une face supérieure (16.2) de la sous-cellule en Ge (16) un diamètre (B3) diminuant ou restant constant avec la profondeur croissante, un angle (a) des surfaces latérales de la première zone par rapport à une perpendiculaire (L) à une surface de fond (26.1) du trou (26) étant de 10° au maximum ou de 2° au maximum ou de 1° au maximum ou de 0,1° au maximum.

6. Procédé selon l'une des revendications précédentes, **caractérisé en ce que** le trou (26) réalisé dans la première et la deuxième partie de processus présente dans une zone allant d'une face supérieure (16.2) de la sous-cellule en Ge (16) à l'intérieur de la sous-cellule en Ge (16) un diamètre (B3) d'au moins 150 µm ou d'au moins 200 µm.

7. Procédé selon l'une des revendications précédentes, **caractérisé en ce que** la sous-cellule en Ge (16) avec la couche de substrat en Ge (14) de la plaquette semi-conductrice préparée (10) présente une épaisseur de couche (D2) de 80 à 300 µm ou de 140 à 160 µm ou de 80 à 120 µm.

8. Procédé selon l'une des revendications précédentes, **caractérisé en ce que** le trou (26) réalisé dans la première et la deuxième partie de processus présente, d'une face supérieure (16.2) de la sous-cellule en Ge (16) à une surface de fond (26.1) du trou (26), une profondeur de 1 à 4 µm ou de 1 à 3 µm ou de 2 µm.

9. Procédé selon l'une des revendications précédentes, **caractérisé en ce que** le premier processus de gravure et/ou le deuxième processus de gravure sont un processus de gravure chimique par voie humide.

10. Procédé selon l'une des revendications précédentes, **caractérisé en ce que** le premier processus de gravure et/ou le deuxième processus de gravure sont un processus de gravure par voie sèche.

11. Procédé selon l'une des revendications précédentes, **caractérisé en ce qu'**après la deuxième étape de processus, un vernis protecteur est appliqué sur la face supérieure (10.1) de la plaquette semi-conductrice (10) et sur toutes les surfaces du trou (26) et une ouverture traversante (32) allant d'une surface de fond (16.2) du trou (26) jusqu'à la face inférieure (10.2) de la plaquette semi-conductrice (10) est réalisée par ablation laser.

12. Procédé selon la revendication 11, **caractérisé en ce qu'**un diamètre (B4) de l'ouverture traversante (32) réalisée par ablation laser est égal à 60 % maximum ou à 20 % maximum ou à 10 % maximum d'un diamètre (B2) du trou (26) sur la face supérieure (10.1) de la plaquette semi-conductrice (10).

13. Procédé selon l'une des revendications précédentes, **caractérisé en ce que** la première ouverture (24) et/ou la deuxième ouverture (30) présentent une périphérie ovale.

14. Procédé selon l'une des revendications, **caractérisé en ce que**, dans la première étape de processus, au moins une première ouverture (24) est réalisée dans la première couche de vernis (22) au-dessus de chaque pile de cellules solaires (12) de la plaquette semi-conductrice (10).
